(19) Europäisches Patentamt
European Patent Office
Office européen des brevets

(11) **EP 4 455 686 A1**

(12) **EUROPEAN PATENT APPLICATION**
published in accordance with Art. 153(4) EPC

(43) Date of publication:
**30.10.2024 Bulletin 2024/44**

(21) Application number: **22909596.3**

(22) Date of filing: **17.11.2022**

(51) International Patent Classification (IPC):
**G01R 19/00** (2006.01)

(52) Cooperative Patent Classification (CPC):
**G01R 19/00**

(86) International application number:
**PCT/CN2022/132437**

(87) International publication number:
**WO 2023/116280 (29.06.2023 Gazette 2023/26)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **21.12.2021 CN 202111569982**

(71) Applicant: **MultiDimension Technology Co., Ltd.
Jiangsu 215634 (CN)**

(72) Inventors:
• **LIU, Mingfeng
Zhangjiagang, Jiangsu 215634 (CN)**
• **SHI, Ran
Zhangjiagang, Jiangsu 215634 (CN)**
• **XUE, Songsheng
Zhangjiagang, Jiangsu 215634 (CN)**

(74) Representative: **HGF
HGF Limited
1 City Walk
Leeds LS11 9DX (GB)**

(54) **STEPPED COPPER-BAR CURRENT MEASUREMENT APPARATUS**

(57) A stepped copper-bar current measurement apparatus. The apparatus comprises: a circuit board (3), a magnetic induction module (2) and a stepped copper bar (1), wherein the magnetic induction module (2) comprises a first magnetic induction unit (211) and a second magnetic induction unit (212); the side of the stepped copper bar (1) facing the magnetic induction module (2) comprises a first step (11) and a second step (12), which are different from each other; the first magnetic induction unit (211) is located above the first step (11), and the second magnetic induction unit (212) is located above the second step (12); a current to be measured flows through the cross section perpendicular to the stepped copper bar (1); the first magnetic induction unit (211) and the second magnetic induction unit (212) induct, in a differential manner, a differential-mode magnetic field which is generated by said current flowing through the stepped copper bar (1), and generate differential voltage signals and output the differential voltage signals. The apparatus has the characteristics of having an adjustable common-mode magnetic field working point, being applicable to various magnetic induction units, having adjustable sensitivity, realizing electrical isolation between an input and an output, having a strong resistance to common-mode interference, being able to measure alternating currents and direct currents, and having a large current.

FIG. 1

EP 4 455 686 A1

## Description

### Technical Field

Embodiments of the present invention relate to the technical field of electrical measurement, and in particular to a current detection device with a stepped copper bar.

### Background

Current detection devices are widely used in industrial automation technology, detection technology, power monitoring systems, inverter power supplies, electric vehicles, and other fields. At present, commonly used current detection devices include shunts based on copper bars to realize signal input, current transformers and Rogowski coils based on the principle of electromagnetic induction, optical fiber current sensors, and magnetic current sensors that use conductive materials to generate magnetic fields for inputs to magnetic induction elements.

The shunt is made based on the principle that voltage is generated across a resistor when direct current passes through it. In essence, it is a resistor with a very small resistance value, which directly applies Ohm's law to convert current signals into voltage signals. There is an electrical connection between a measured current loop and a measuring loop of a shunt, and there is no electrical isolation between a signal output end and the measured current loop, which causes mutual interference between the two. It is suitable for low frequency and low power, cannot measure the current of high voltage loops, and is also difficult to measure high AC currents.

Current transformers are based on the principle of electromagnetic induction and can only measure changing currents. A closed-type current transformer requires the busbar to be removed before installation or disassembly, and has a complex structure; the magnetic circuit of an open-type current transformer has an air gap, which makes the product itself have a relatively large error and a large size. The Rogowski coil is similar to a current transformer and adopts an air core design. It can be directly put on a conductor to be measured and is suitable for measuring AC current in a wide frequency range, but cannot measure DC current. It has low sensitivity and a large size.

The functional fiber optic sensor in a fiber optic current sensor is based on the Faraday effect of magneto-optical crystals. It uses optical fiber that is sensitive to and capable of detecting external information as a sensing element. It has high measurement accuracy and is easy to be miniaturized, but it must use special optical fibers and is costly.

Magnetic current sensors use different structural designs of current-carrying conductor materials to generate a magnetic field in space, then use various magnetic induction elements to sense the magnetic field, and output a voltage signal, thereby realizing the detection of a current. Interference has a great influence on the current measurement accuracy. The current measurement accuracy thereof can be improved by improving the anti-interference ability of a magnetic current sensor. The design generally adopted for the anti-interference capability of existing magnetic current sensors is using a difference in magnetic fields generated by current-carrying conductors at different locations in space to perform differential testing of the magnetic field through magnetic induction elements.

The current measurement realized in a differential mode includes: (1) a current detection method using two magnetic induction elements to sense, in a differential manner, the magnetic field inside the same annular iron core; however, there is a magnetic leakage problem in the air gap of the iron core and the volume and weight of the magnetic ring structure are large. Since the magnetic lines of force inside the same annular iron core directly pass through a magnetic sensing unit, it is difficult to adjust the common mode magnetic field working point and the input signal range, and when measuring large currents, the magnetic sensing unit is easily saturated; and (2) using U-shaped wires to generate differential signals in opposite directions, or using a copper bar with a neck depression as a signal input, or using a copper busbar wire to be measured with a rectangular or rounded rectangular cross-section as a signal input; however, when the current is large, the magnetic field generated by the current to be measured passing through the above wires is directly used as the input signal of the magnetoresistive sensitive element for differential detection, and therefore, when measuring large currents, the common mode magnetic field will saturate the magnetoresistive sensor chip, resulting in a limited input range.

### Summary of the Invention

Embodiments of the present invention provide a current detection device with a stepped copper bar to solve the problems of existing current sensors of limited measurement accuracy and measurement range.

An embodiment of the present invention provides a current detection device with a stepped copper bar, comprising:

a circuit board;
a magnetic induction module secured on the circuit board, the magnetic induction module at least comprising a first magnetic sensing unit and a second magnetic sensing unit, wherein the first magnetic sensing unit and the second magnetic sensing unit are located on the same horizontal plane, and the horizontal plane is parallel to the plane where the circuit board is located; and

a stepped copper bar, wherein the side of the stepped copper bar facing the magnetic induction module is stepped, the stepped copper bar at least comprises a first step and a second step different from the first step; in a direction perpendicular to the circuit board, the first magnetic sensing unit is located above the first step, and the second magnetic sensing unit is located above the second step; and the stepped copper bar is electrically isolated from the magnetic induction module;

wherein a current to be measured flows through a cross section perpendicular to the stepped copper bar, and the first magnetic sensing unit and the second magnetic sensing unit sense, in a differential manner, a differential mode magnetic field generated by the current to be measured flowing through the stepped copper bar, and generate and output a differential voltage signal.

The embodiment of the present invention further provides a current detection device with a stepped copper bar, comprising: a stepped copper bar, a current shunting copper bar, a magnetic induction module, and a circuit board, wherein the magnetic induction module is fixed on the circuit board;

the stepped copper bar and the current shunting copper bar are connected in series and parallel to form a to-be-measured current input module, the magnetic induction module and the circuit board form a signal output module, and the to-be-measured current input module is electrically isolated from the signal output module;
the side of the stepped copper bar facing the magnetic induction module is stepped, and the stepped copper bar comprises at least a first step and a second step;
the magnetic induction module at least comprises a first magnetic sensing unit and a second magnetic sensing unit, the first magnetic sensing unit and the second magnetic sensing unit are located on the same horizontal plane, the horizontal plane is parallel to the plane where the circuit board is located, and in a direction perpendicular to the circuit board, the first magnetic sensing unit is located above the first step, and the second magnetic sensing unit is located above the second step;
a current to be measured flows through a cross section perpendicular to the stepped copper bar and the current shunting copper bar, and generates a magnetic field at the position of the magnetic induction module; the first magnetic sensing unit and the second magnetic sensing unit sense, in a differential manner, the magnetic field generated by the current to be measured flowing through the to-be-measured current input module, and generate a voltage signal, which forms an output signal of the current detection device with a stepped copper bar.

In the current detection device with a stepped copper bar provided by the embodiment of the present invention, the stepped copper bar has a first step and a second step with a height difference, and the magnetic sensing units in the magnetic induction module sense the differential mode magnetic field generated by the height difference between the first step and the second step in a differential manner; since the cross-sectional current density of the stepped copper bar is the same, by adjusting the height of the first step and the second step, most of the current to be measured can flow through the lower rectangle of the stepped copper bar away from the magnetic induction module and form a common mode magnetic field, and at the same time, the size of the differential mode magnetic field can be adjusted and controlled, so that the measurement current range can be expanded. The current detection device with a stepped copper bar has the characteristics of adjustable common mode magnetic field working points, applicability to a variety of magnetic sensing units, adjustable sensitivity, input and output electrical isolation, strong anti-common mode interference capability, capability of measuring DC and AC currents, and capability of measuring large currents.

## Description of the Drawings

In order to more clearly illustrate the technical solutions in the embodiments of the present invention or the prior art, the accompanying drawings required for use in the embodiments or the prior art are briefly introduced below. Obviously, although the accompanying drawings described below are some specific embodiments of the present invention, for those skilled in the art, the basic concepts of the device structure, driving method, and manufacturing method disclosed and prompted by the various embodiments of the present invention can be expanded and extended to other structures and drawings, and there is no doubt that these should all fall within the scope of the claims of the present invention.

FIG. 1 is a schematic diagram of a current detection device with a stepped copper bar according to an embodiment of the present invention;
FIG. 2 is a magnetic field simulation diagram of the current detection device with a stepped copper bar shown in FIG. 1;

FIG. 3 is a schematic diagram of the bridge structure of the current detection device with a stepped copper bar shown in FIG. 1;

FIG. 4 is a schematic diagram of a voltage-magnetic field curve of a current detection device of a magnetoresistive sensitive element;

FIG. 5 is a schematic diagram of another current detection device with a stepped copper bar according to an embodiment of the present invention;

FIG. 6 is a magnetic field simulation diagram of the current detection device with a stepped copper bar shown in FIG. 5;

FIG. 7 is a schematic diagram of the bridge structure of the current detection device with a stepped copper bar shown in FIG. 5;

FIG. 8 is a schematic diagram of still another current detection device with a stepped copper bar according to an embodiment of the present invention;

FIG. 9 is a magnetic field simulation diagram of the current detection device with a stepped copper bar shown in FIG. 8; and

FIG. 10 is a schematic diagram of still another current detection device with a stepped copper bar according to an embodiment of the present invention.

## Detailed Description

In order to make the purpose, technical solutions, and advantages of the present invention clearer, the technical solutions of the present invention will be clearly and completely described below through implementations with reference to the accompanying drawings in the embodiments of the present invention. Obviously, the described embodiments are some, rather than all, embodiments of the present invention. Based on the basic concepts disclosed and prompted by the embodiments of the present invention, all other embodiments obtained by those skilled in the art fall within the protection scope of the present invention.

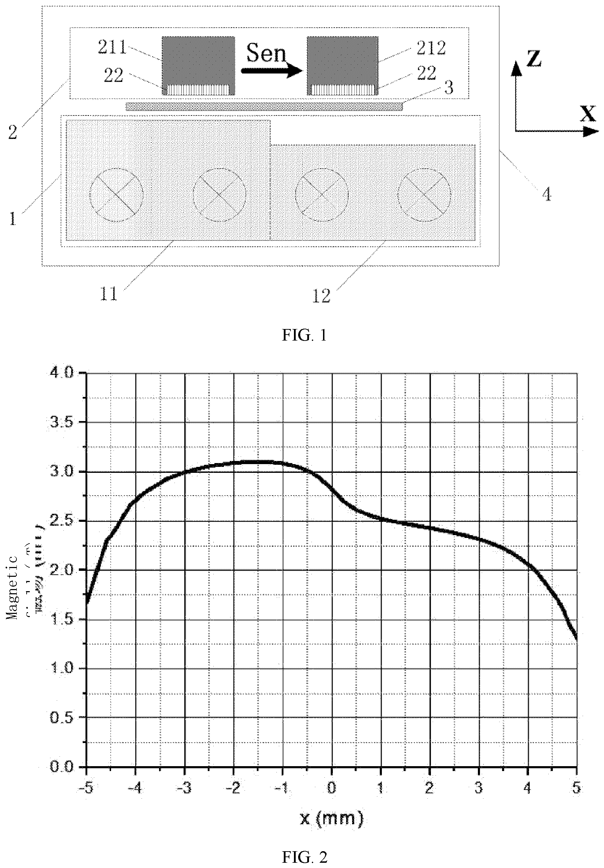

Referring to FIG. 1, which is a schematic diagram of a current detection device with a stepped copper bar according to an embodiment of the present invention. The current detection device with a stepped copper bar provided in the present embodiment comprises: a circuit board 3, a magnetic induction module 2 fixed on the circuit board 3, the magnetic induction module 2 at least comprising a first magnetic sensing unit 211 and a second magnetic sensing unit 212, the first magnetic sensing unit 211 and the second magnetic sensing unit 212 being located on the same horizontal plane, and the horizontal plane is parallel to the plane where the circuit board 3 is located; a stepped copper bar 1, the side of the stepped copper bar 1 facing the magnetic induction module 2 is step shaped, the stepped copper bar 1 at least comprises a first step 11 and a second step 12 different from the first step 11, and in a direction perpendicular to the circuit board 3, the first magnetic sensing unit 211 is located above the first step 11, and the second magnetic sensing unit 212 is located above the second step 12, the stepped copper bar 1 being electrically isolated from the magnetic induction module 2; a current to be measured flows through a cross section perpendicular to the stepped copper bar 1, and the first magnetic sensing unit 211 and the second magnetic sensing unit 212 sense, in a differential manner, a differential mode magnetic field generated by the current to be measured flowing through the stepped copper bar 1, and generate and output a differential voltage signal.

In this embodiment, the current detection device with a stepped copper bar is provided with a stepped copper bar and a magnetic induction module, and therefore, the current detection device with a stepped copper bar is also a magnetoresistive current detection device. The specific working principle is that the magnetic induction module 2 senses, in a differential manner, the differential mode magnetic field generated by the current to be measured flowing through the step-shaped part of the stepped copper bar 1.

Optionally, the current detection device with a stepped copper bar also includes: a mechanical support housing 4, which wraps, fixes, and supports the magnetic induction module 2 and the stepped copper bar 1. The mechanical support housing 4 not only wraps, fixes, and supports the various parts of the current detection device with a stepped copper bar, but also provides an external interface.

The current detection device with a stepped copper bar includes a circuit board 3. It can be understood that the plane where the circuit board 3 is located is perpendicular to the Z direction. In the direction Z perpendicular to the plane where the circuit board 3 is located, optionally, the magnetic induction module 2, the circuit board 3, and the stepped copper bar 1 are arranged in sequence, that is, the magnetic induction module 2 and the stepped copper bar 1 are located on opposite sides of the circuit board 3. Optionally, along the Z direction, the magnetic induction module 2 is fixedly arranged above the circuit board 3, the stepped copper bar 1 is arranged below the circuit board 3, the stepped copper bar 1 is electrically isolated from the magnetic induction module 2, and the stepped copper bar 1 is also electrically isolated from the circuit board 3.

The side of the stepped copper bar 1 facing the magnetic induction module 2 is stepped, and the cross section of the stepped copper bar 1 is a cross section obtained by cutting with the X-Z plane as the cutting plane, so the cross section of the stepped copper bar 1 is parallel to the X-Z plane. FIG. 1 shows a cross section of the magnetic induction module 2, the circuit board 3, and the stepped copper bar 1. The side of the stepped copper bar 1 facing the magnetic induction module 2 is stepped, and at least includes a first step 11 and a second step 12 different from the first step 11.

The magnetic induction module 2 at least includes a first magnetic sensing unit 211 and a second magnetic sensing unit 212, the first magnetic sensing unit 211 and the second magnetic sensing unit 212 are located on the same horizontal plane, and the horizontal plane is parallel to the plane where the circuit board 3 is located. In the direction Z perpendicular to the circuit board 3, the first magnetic sensing unit 211 is located above the first step 11, and the second magnetic sensing unit 212 is located above the second step 12.

Optionally, the sensitivity directions of the magnetic sensing units in the magnetic induction module 2 are the same, and the sensitivity directions of the magnetic sensing units are the same as or opposite to the direction of the magnetic field generated by the stepped copper bar 1 at the position of the magnetic sensing units. In this embodiment, the sensitivity directions of the first magnetic sensing unit 211 and the second magnetic sensing unit 212 are the same, and their sensitivity directions are optionally the rightward x direction as shown in the figure. The direction of the magnetic field generated by the stepped copper bar 1 at the positions of the first magnetic sensing unit 211 and the second magnetic sensing unit 212 is the same as the sensitivity directions of the magnetic sensing units, so the direction of the magnetic field generated by the stepped copper bar 1 at the positions of the first magnetic sensing unit 211 and the second magnetic sensing unit 212 is also the rightward X direction as shown in the figure. It can be understood that the sensitivity directions of the magnetic sensing units shown to be rightward are only an example, and relevant practitioners can reasonably design the sensitivity direction of a magnetic sensing unit according to product requirements, which is not limited to the rightward direction shown in the figure.

The current to be measured flows through the stepped copper bar 1 in a current direction perpendicular to the cross section of the stepped copper bar 1. Specifically, the current direction is perpendicular to the X-Z plane and is perpendicular to the paper surface and inward. The first magnetic sensing unit 211 and the second magnetic sensing unit 212 sense, in a differential manner, the differential mode magnetic field generated by the current to be measured flowing through the stepped copper bar 1, and generate and output a differential voltage signal

The specific analysis process is as follows. FIG. 2 is a magnetic field simulation diagram of the current detection device with a stepped copper bar shown in FIG. 1; The current $I_1$ of the stepped copper bar 1 is 50 A, the width of the cross section of the stepped copper bar 1 along the Z direction is 10 mm, and the magnetic induction module 2 is located at a horizontal plane position 0.6 mm above the stepped copper bar 1. When the current to be measured flows through the stepped copper bar 1 in a current direction perpendicular to the X-Z plane, a magnetic field is generated at the position of the magnetic induction module 2. The simulation diagram is shown in FIG. 2, from which it can be seen that near the step rising section, the magnetic fields in the same plane above the first step 11 and the second step 12 have an obvious difference, and the magnetic field distribution is relatively uniform.

Assume that the first magnetic sensing unit 211 is located in a uniform magnetic field area above the first step 11, and the second magnetic sensing unit 212 is located in a uniform magnetic field area above the second step 12. Since the material of the stepped copper bar 1 is considered to be uniform, when the current to be measured flows through the stepped copper bar 1 in a current direction perpendicular to the X-Z plane, the current density in the step cross section can be considered to be the same, that is, the current magnitude is proportional to the cross-sectional area. Therefore, the stepped copper bar 1 can be re-divided into two, that is, upper and lower rectangular cross-sectional parts according to the first step 11 and the second step 12. The height of the lower rectangle divided in the stepped copper bar 1 is consistent with the height of the second step 12, and the width of the lower rectangle is the sum of the width of the first step 11 and the width of the second step 12; the height of the upper rectangle is the difference between the height of the first step 11 and the height of the second step 12, and the width of the upper rectangle is consistent with the width of the first step 11. Here, the height is the dimension along the Z direction, and the width is the dimension along the X direction.

Based on this, it can be considered that the first magnetic sensing unit 211 and the second magnetic sensing unit 212 are both located in the lower rectangular uniform magnetic field area, and the first magnetic sensing unit 211 is also located in the upper rectangular uniform magnetic field area.

Let the current to be measured be $I_{in}$, and the current flowing through the stepped copper bar 1 be $I_1$, then the current $I_1$ flowing through the stepped copper bar 1 can be divided into the current $I'_1$ flowing through the lower rectangle and the current $\Delta I_1$ flowing through the upper rectangle, and equation (1) is obtained:

$$I_1 = I'_1 + \Delta I_1 \ (1).$$

Taking the rightward X direction as the positive direction of the magnetic field, according to the Biot-Savart Law that a current-carrying wire generates a magnetic field, the magnetic field $H_{211}$ generated by the current $I_1$ of the stepped copper bar 1 at the position of the first magnetic sensing unit 211 changes linearly with the current, the magnetic field $H_{212}$ generated by the current $I_1$ at the position of the second magnetic sensing unit 212 changes linearly with the current, and equation (2) is obtained:

$$H_{211}=k_1I'_1+k_{21}\Delta I_1;$$

$$H_{212}=k_1I'_1+k_{22}\Delta I_1 \qquad (2).$$

wherein $k_1$ is the linear constant of the uniform magnetic field generated by the lower rectangular current $I'_1$ at the positions of the first magnetic sensing unit 211 and the second magnetic sensing unit 212, $k_{21}$ is the linear constant of the magnetic field generated by the upper rectangular current $\Delta I_1$ at the position of the first magnetic sensing unit 211, and $k_{22}$ is the linear constant of the magnetic field generated by the upper rectangular current $\Delta I_1$ at the position of the second magnetic sensing unit 212.

By performing equivalent transformation on the equation (2), the magnetic field at the positions of the first magnetic sensing unit 211 and the second magnetic sensing unit 212 is decomposed into a common mode magnetic field $H_{CM}$ and a differential mode magnetic field $H_{DM}$, and equation (3) is obtained:

$$H_{CM}=\tfrac{1}{2}(H_{211}+H_{212})=k_1I'_1+\tfrac{1}{2}(k_{21}+k_{22})\Delta I_1$$

$$H_{DM}=\tfrac{1}{2}(H_{211}-H_{212})=\tfrac{1}{2}(k_{21}-k_{22})\Delta I_1 \qquad (3).$$

Correspondingly, the magnetic field at the position of the first magnetic sensing unit 211 and the magnetic field at the position of the second magnetic sensing unit 212 can be converted into a superposition expression of a common mode magnetic field $H_{CM}$ and a differential mode magnetic field $H_{DM}$, and equation (4) is obtained:

$$H_{211}=H_{CM}+H_{DM};$$

$$H_{212}=H_{CM}-H_{DM} \qquad (4).$$

As described above, in the current detection device with a stepped copper bar provided by this embodiment, $I_{in}=I_1$. Combining equations (3) and (4), it can be seen that the magnetic field at the positions of the first magnetic sensing unit 211 and the second magnetic sensing unit 212 is proportional to the current to be measured $I_{in}$, and the current to be measured can be detected by measuring the differential mode magnetic field $H_{DM}$.

In the current detection device with a stepped copper bar provided by the embodiment of the present invention, the stepped copper bar has a first step and a second step with a height difference, and the magnetic sensing units in the magnetic induction module sense the differential mode magnetic field generated by the height difference between the first step and the second step in a differential manner; since the current density of the stepped copper bar is the same over the cross section, by adjusting the height of the first step and the second step, most of the current to be measured can flow through the lower rectangle on the side of the stepped copper bar away from the magnetic induction module and form a common mode magnetic field, and at the same time, the size of the differential mode magnetic field can be adjusted and controlled, so that the measurement current range can be expanded. The current detection device with a stepped copper bar has the characteristics of adjustable common mode magnetic field working points, applicability to a variety of magnetic sensing units, adjustable sensitivity, input and output electrical isolation, strong resistance to common mode interference, and ability to measure large AC and DC currents.

Optionally, the magnetic sensing units in the magnetic induction module are composed of any magnetoresistive sensitive element from anisotropic magnetoresistor AMR, giant magnetoresistor GMR, tunnel magnetoresistor TMR, and colossal magnetoresistor CMR.

Optionally, the first magnetic sensing unit at least comprises one magnetoresistive bridge arm, and the second magnetic sensing unit at least comprises one magnetoresistive bridge arm; the magnetoresistive bridge arm of the first magnetic sensing unit and the magnetoresistive bridge arm of the second magnetic sensing unit are electrically connected to form a differential half-bridge structure output or connected to form a differential full-bridge structure output, wherein all magnetoresistive bridge arms have the same sensitivity direction, and the magnetoresistive bridge arm is formed by connecting at least one magnetoresistive sensitive element in series and parallel; and the first magnetic sensing unit and the second magnetic sensing unit are located on the same chip or on two separate chips.

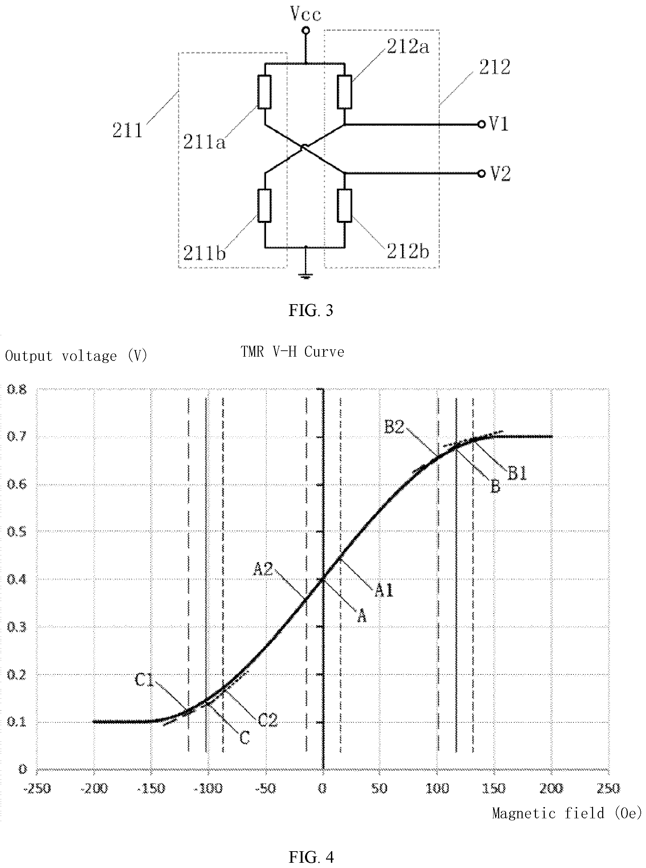

FIG. 3 is a schematic diagram of the bridge structure of the current detection device with a stepped copper bar shown in FIG. 1. Here, the bridge structure of the current detection device with a stepped copper bar is a differential full-bridge structure. As shown in FIG. 3, optionally, the first magnetic sensing unit 211 includes two magnetoresistive bridge arms 211a and 211b, and the second magnetic sensing unit 212 includes two magnetoresistive bridge arms 212a and 212b; the four magnetoresistive bridge arms 211a, 211b, 212a, and 212b are electrically connected to form a differential full-bridge structure. The sensitivity directions of the four magnetoresistive bridge arms 211a, 211b, 212a, and 212b are the same, which are all horizontally to the right in the X direction. Each magnetoresistive bridge arm is composed of at least one magnetoresistive sensitive element connected in series and in parallel. Optionally, the magnetoresistive sensitive element of the magnetoresistive bridge arm adopts a tunnel magnetoresistor TMR; and optionally, the first magnetic sensing unit 211 and the second magnetic sensing unit 212 are located on the same chip.

By combining the above analysis and the differential full-bridge structure shown in FIG. 3, it can be seen that there is a difference between the magnetic field generated by the stepped copper bar 1 at the position of the first magnetic sensing unit 211 and the magnetic field generated by the stepped copper bar 1 at the position of the second magnetic sensing unit 212. Specifically, the rightward magnetic field generated by the stepped copper bar 1 at the position of the first magnetic sensing unit 211 is greater than the rightward magnetic field generated by the stepped copper bar 1 at the position of the second magnetic sensing unit 212. Since the sensitivity directions of the four magnetoresistive bridge arms 211a, 211b, 212a, and 212b are all rightward, the rightward magnetic field at the positions of the magnetoresistive bridge arms 211a and 211b is greater than the rightward magnetic field at the positions of the magnetoresistive bridge arms 212a and 212b. Therefore, the resistance of the magnetoresistive bridge arms 211a and 211b is smaller than the resistance of the magnetoresistive bridge arms 212a and 212b. Therefore, it can be obtained that the V2 voltage is greater than the V1 voltage, forming a differential voltage signal.

Optionally, the magnetic induction module 2 also includes a closed-loop signal conditioning circuit and a magnetic field feedback coil 22, and the closed-loop signal conditioning circuit, the magnetic field feedback coil 22, the first magnetic sensing unit 211, and the second magnetic sensing unit 212 constitute a closed-loop magnetic field feedback component; after the differential voltage signal is amplified by the closed-loop signal conditioning circuit, a feedback magnetic field is generated through the magnetic field feedback coil 22 to reversely offset the differential mode magnetic field; when the dynamic balance of the magnetic field is reached, the first magnetic sensing unit 211 and the second magnetic sensing unit 212 operate at equal common mode magnetic field operating points, and then the feedback current of the magnetic field feedback coil 22 is sampled through a sampling resistor to form an output signal of the magnetic induction module 2. Alternatively, in other embodiments, optionally, the magnetic induction module also includes an open-loop signal conditioning circuit, which performs conditioning, amplification, temperature compensation, and linearity correction on the differential voltage signal.

In this embodiment, optionally, the magnetic field feedback coil 22 and the closed-loop signal conditioning circuit are integrated inside the magnetic sensing unit. For example, the first magnetic sensing unit 211 has a magnetic field feedback coil 22 and a closed-loop signal conditioning circuit integrated therein, the second magnetic sensing unit 212 has a magnetic field feedback coil 22 and a closed-loop signal conditioning circuit integrated therein, and optionally, the closed-loop signal conditioning circuit is made of an ASIC application-specific integrated circuit.

The closed-loop signal conditioning circuit is used to condition, amplify, temperature compensate, and perform linearity correction on the differential voltage signal generated between the first magnetic sensing unit 211 and the second magnetic sensing unit 212 . After the differential voltage signal is amplified by the closed-loop signal conditioning circuit, it passes through the magnetic field feedback coil 22 to generate a feedback magnetic field to reversely offset the differential mode magnetic field. When the dynamic balance of the magnetic field is achieved, the first magnetic sensing unit 211 and the second magnetic sensing unit 212 operate at equal common mode magnetic field operating points. Finally, the feedback current of the magnetic field feedback coil 22 is sampled by the sampling resistor to form the output of the magnetic induction module 2. At this time, the output signal of the magnetic induction module 2 forms the output signal of the current detection device with a stepped copper bar.

In the current detection device with a stepped copper bar provided in this embodiment, the first magnetic sensing unit and the second magnetic sensing unit in the magnetic induction module adopt a full-bridge circuit structure and are located on the same chip, which can enhance the anti-interference ability and consistency; the step shape of the stepped copper bar can enable the magnetic induction module to form a differential mode magnetic field; the magnetic field feedback coil is integrated inside the magnetic sensing unit. Based on this, the current detection device with a stepped copper bar has the characteristics of simple structure, small size, input and output electrical isolation, strong anti-common mode interference capability, capability of measuring DC and AC currents, and capability of measuring large currents.

In other embodiments, the bridge structure of the current detection device with a stepped copper bar can also be selected as a differential half-bridge structure, wherein the first magnetic sensing unit includes a magnetoresistive bridge arm, and the second magnetic sensing unit includes a magnetoresistive bridge arm; the two magnetoresistive bridge arms are electrically connected to form a differential half-bridge structure output, and all the magnetoresistive bridge arms have the same sensitivity direction and are composed of at least one magnetoresistive sensitive element connected in series and parallel; the first magnetic sensing unit and the second magnetic sensing unit are located on the same chip or on two separate chips. Optionally, the magnetic induction module also includes an open-loop signal conditioning circuit, which performs conditioning, amplification, temperature compensation, and linearity correction on the differential voltage signal. Its working principle is similar to that of FIG. 3 and will not be described again here.

It should be noted that only using the stepped copper bar 1 to form a magnetic field can expand the measurement current range to a degree, but the degree of expansion is still limited. Specifically, the common mode magnetic field $H_{CM}$ can be separated through the cross section of the stepped copper bar 1, thereby expanding the measurement current range, that is, the common mode magnetic field $H_{CM}$ has the same effect on the first magnetic sensing unit 211 and the second magnetic sensing unit 212, and theoretically has no effect on the output of the magnetic induction module 2; however, due to the characteristics of the magnetoresistive sensitive element itself, there will still be certain linearity consistency problems and saturation problems.

Referring to FIG. 4, it is a schematic diagram of a voltage-magnetic field curve of a magnetoresistive sensitive element. Optionally, the magnetoresistive sensitive element in the magnetic induction module 2 is a tunnel magnetoresistor TMR. As shown in FIG. 4, there is a certain range of linear intervals on both sides of the magnetic field zero point, and when it approaches saturation, the sensitivity of the tunnel magnetoresistor TMR will change, which is reflected in the change of the slope of the curve in FIG. 4. Specifically, point A is in the linear range, point B is in the positive saturation approaching range, and point C is in the negative saturation approaching range.

According to the above equation (4), it can be assumed that the working points of the common mode magnetic field $H_{CM}$ in the three cases are A, B, and C, the working points of $H_{211}$ are A1, B1, and C1, the working points of $H_{212}$ are A2, B2, and C2, the difference between $H_{211}$ and $H_{CM}$ is $H_{DM}$, and the difference between $H_{212}$ and $H_{CM}$ is $H_{DM}$.

At point A in the linear range, the sensitivities of the first magnetic sensing unit 211 and the second magnetic sensing unit 212 are consistent; while at points B and C in the saturation approaching range, there will be errors in the sensitivities of the first magnetic sensing unit 211 and the second magnetic sensing unit 212, that is, the slopes at B 1 and B2 are quite different, and the slopes at C1 and C2 are quite different, which will affect the measurement accuracy of the current detection device.

Similarly, for input currents of different sizes, the common mode magnetic fields generated are different, which makes the sensitivity of the current detection device with a stepped copper bar also have certain differences over the full range, so there will be certain problems with linearity consistency. The above reasons limit the further expansion of the measurement current range.

Based on this, an embodiment of the present invention further provides another current detection device with a stepped copper bar, which is different from any of the above embodiments in that a current shunting copper bar is introduced into the current detection device with a stepped copper bar provided in this embodiment and the following embodiments. The role of the current shunting copper bar in the current detection device with a stepped copper bar is, on the one hand, to further shunt a current to be measured and expand the measurement current range; and on the other hand, it can reduce and offset the common mode magnetic field, so that the working point of the magnetic induction module returns from the saturation approaching range to the linear range. Then, while considering the linearity consistency, the measurement current range can be significantly expanded.

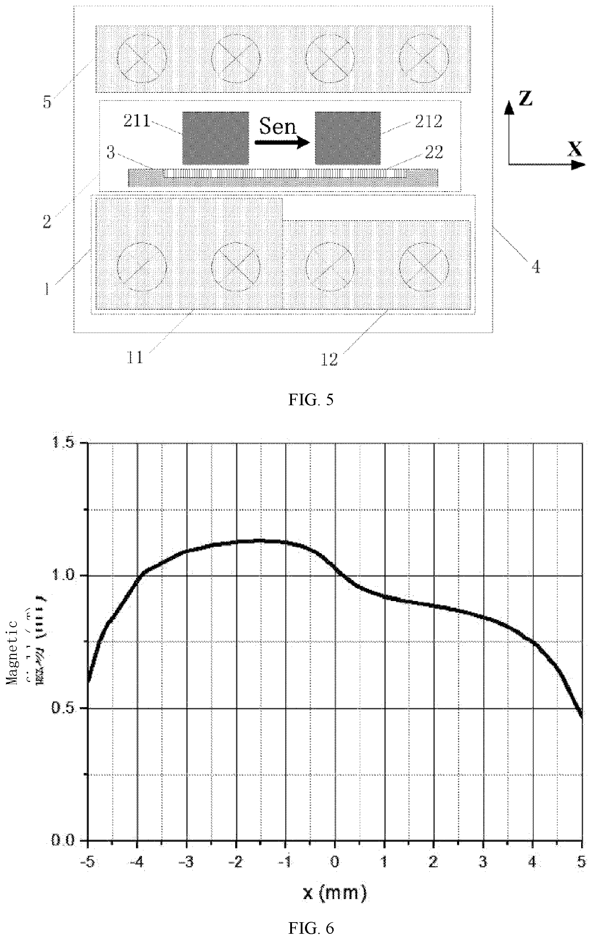

Referring to FIG. 5, which is a schematic diagram of another current detection device with a stepped copper bar according to an embodiment of the present invention. As shown in FIG. 5, the current detection device with a stepped copper bar provided in this embodiment includes: a stepped copper bar 1, a current shunting copper bar 5, a magnetic induction module 2, and a circuit board 3, wherein the magnetic induction module 2 is fixed on the circuit board 3; the stepped copper bar 1 and the current shunting copper bar 5 are connected in series and parallel to form a to-be-measured current input module, the magnetic induction module 2 and the circuit board 5 form a signal output module, and the to-be-measured current input module is electrically isolated from the signal output module; the side of the stepped copper bar 1 facing the magnetic induction module 2 is step shaped, and the stepped copper bar 1 at least includes a first step 11 and a second step 12; the magnetic induction module 2 at least includes a first magnetic sensing unit 211 and a second magnetic sensing unit 212, the first magnetic sensing unit 211 and the second magnetic sensing unit 212 are located on the same horizontal plane, and the horizontal plane is parallel to the plane where the circuit board 3 is located. In the direction Z perpendicular to the circuit board 3, the first magnetic sensing unit 211 is located above the first step 11, and the second magnetic sensing unit 212 is located above the second step 12; the current to be measured flows through the cross section perpendicular to the stepped copper bar 1 and the current shunting copper bar 5, and generates a magnetic field at the position of the magnetic induction module 2; the first magnetic sensing unit 211 and the second magnetic sensing unit 212 sense, in a differential manner, the magnetic field generated by the current to be measured flowing through the to-be-measured current input module, and generate a voltage signal, which forms the output signal of the current detection device with a stepped copper bar.

In this embodiment, a current shunting copper bar 5 is introduced, wherein the stepped copper bar 1 and the current shunting copper bar 5 are located on the upper and lower sides of the magnetic induction module 2. The magnetic induction module 2 is fixed on the circuit board 3, and the plane where the circuit board 3 is located is optionally perpendicular to the Z direction. Along the Z direction, the stepped copper bar 1 and the current shunting copper bar 5 are located on the upper and lower sides of the circuit board 3, and optionally, the stepped copper bar 1 is located below the circuit board 3, the current shunting copper bar 5 is located above the circuit board 3, and the magnetic induction module 2 is secured above the circuit board 3.

The stepped copper bar 1 and the current shunting copper bar 5 are connected in series and parallel to form a to-be-measured current input module, the magnetic induction module 2 and the circuit board 5 form a signal output module, and the to-be-measured current input module is electrically isolated from the signal output module; The plane where the circuit board 3 is located is perpendicular to the Z direction, so the cross section of the circuit board 3 is parallel to the X-Z plane, and accordingly, the cross sections of the stepped copper bar 1 and the current shunting copper bar 5 are both parallel to the X-Z plane. The current to be measured flows through a cross section perpendicular to the stepped copper bar 1 and the current shunting copper bar 5. Optionally, the current shunting copper bar 5 can be connected in parallel with the stepped copper bar 1 to realize common shunting of the current to be measured, so that the current to be measured flows through the stepped copper bar 1 and the current shunting copper bar 5 in the same direction, both of which are perpendicular to the paper surface and inward.

Optionally, in the direction Z perpendicular to the circuit board 3, the vertical projection of the current shunting copper bar 5 on the circuit board 3 covers the vertical projection of each magnetic sensing unit in the magnetic induction module 2 on the circuit board 3; the sensitivity direction of each magnetic sensing unit is the same, and the sensitivity direction of the magnetic sensing unit is the same as or opposite to the direction of the magnetic field generated by the stepped copper bar 1 at the position of the magnetic sensing unit, and the sensitivity direction of the magnetic sensing unit is along the plane of the magnetic induction module 2 and perpendicular to the step rising cross-section direction of the stepped copper bar 1. The current shunting copper bar 5 is located above the first magnetic sensing unit 211 and the second magnetic sensing unit 212, and the first magnetic sensing unit 211 and the second magnetic sensing unit 212 are both located in a uniform magnetic field area within the coverage range of the vertical projection of the current shunting copper bar 5 along the Z direction. Specifically, the first magnetic sensing unit 211 is located in a uniform magnetic field area above the first step 11, and the second magnetic sensing unit 212 is located in a uniform magnetic field area above the second step 12.

Optionally, the first magnetic sensing unit 211 and the second magnetic sensing unit 212 are located on the same circuit board 3; alternatively, the first magnetic sensing unit 211 and the second magnetic sensing unit 212 are located on two separate circuit boards 3.

Optionally, the magnetic sensing units in the magnetic induction module 2 are composed of any magnetoresistive sensitive element from anisotropic magnetoresistor AMR, giant magnetoresistor GMR, tunnel magnetoresistor TMR, and colossal magnetoresistor CMR. Alternatively, optionally, the magnetic sensing units in the magnetic induction module 2 are composed of any magnetic induction element of a fluxgate, a giant magneto-impedance GMI, and a magneto-electric coupling device ME.

Optionally, the number of current shunting copper bars is one or more; along the vertical direction Z of the circuit board 3, the position of any current shunting copper bar is above the magnetic induction module 2 or below the stepped copper bar 1, and the vertical projection of the current shunting copper bar on the plane where the circuit board 3 is located covers each magnetic sensing unit in the magnetic induction module 2. Optionally, at the position of the magnetic induction module 2, the current direction of the current shunting copper bar is the same as or opposite to the current direction of the stepped copper bar 1; in the current detection device with a stepped copper bar, the input range of the current to be measured of the current detection device with a stepped copper bar is adjusted by setting the series-parallel connection mode of the current shunting copper bar and the stepped copper bar 1, and/or the input range of the current to be measured of the current detection device with a stepped copper bar is adjusted by setting the number of current shunting copper bars.

As shown in FIG. 5, the current detection device with a stepped copper bar introduces a current shunting copper bar 5, and the current shunting copper bar 1 is located above the magnetic induction module 2; at the position of the magnetic induction module 2, the current direction of the current shunting copper bar 5 is the same as the current direction of the stepped copper bar 1; the current shunting copper bar 5 shunts the current to be measured, and by setting the series-parallel connection mode of the current shunting copper bar 5 and the stepped copper bar 1, the input range of the current to be measured of the current detection device with a stepped copper bar can be adjusted, thereby further expanding the measurement current range.

The current to be measured flows through the stepped copper bar 1 and the current shunting copper bar 5 in a current direction perpendicular to a cross section of the stepped copper bar 1 and the current shunting copper bar 5, and generates a magnetic field at the position of the magnetic induction module 2; the first magnetic sensing unit 211 and the second magnetic sensing unit 212 sense, in a differential manner, the magnetic field generated by the current to be measured flowing through the to-be-measured current input module, and generate a voltage signal, which forms an output signal of the current detection device with a stepped copper bar. Here, the current shunting copper bar 5 generates a leftward common mode magnetic field at the positions of the magnetic sensing units.

The specific analysis process is as follows. Referring to FIG. 6, which is a magnetic field simulation diagram of the current detection device with a stepped copper bar shown in FIG. 5. By comparing FIG. 6 with FIG. 2, it can be seen that the similarities are that, near the step rising section, the magnetic fields in the same plane above the first step 11 and the second step 12 have an obvious difference, and the magnetic field distribution is relatively uniform; and the difference is that the magnetic field curve shown in FIG. 6 has a significant downward shift, that is, the leftward common mode magnetic field generated by the current shunting copper bar 5 at the position of the magnetic sensing unit and the rightward common mode magnetic field generated by the stepped copper bar 1 offset and reduce each other. Obviously, by adjusting the thickness and relative position of the current shunting copper bar 5, the offset common mode magnetic fields may be of the same direction, zeroed, or of the opposite directions.

The following is explained by taking the curve shown in FIG. 6 as an example. It can be understood that the offset common mode magnetic fields of the current shunting copper bar 5 and the stepped copper bar 1 are of the same direction.

Let the current flowing through the current shunting copper bar 5 be $I_5$, then equation (5) is obtained:

$$I_{in} = I_1 + I_5 = I'_1 + \Delta I_1 + I_5 \qquad (5).$$

Taking the rightward X direction as the positive direction of the magnetic field, assuming that the first magnetic sensing unit 211 and the second magnetic sensing unit 212 are located in the uniform magnetic field area of the current shunting copper bar 5, and equation (6) is obtained according to the Biot-Savart Law that a current-carrying wire generates a magnetic field:

$$H_{211} = k_1 I'_1 + k_{21} \Delta I_1 - k_3 I_5;$$

$$H_{212} = k_1 I'_1 + k_{22} \Delta I_1 - k_3 I_5 \qquad (6).$$

wherein $k_3$ is the linear constant of a uniform magnetic field generated by the current $I_5$ of the current shunting copper bar 5 at the positions of the first magnetic sensing unit 211 and the second magnetic sensing unit 212.

By performing equivalent transformation on the equation (6), equation (7) is obtained:

$$H_{CM} = \tfrac{1}{2}(H_{211} + H_{212}) = -k_3 I_5 + k_1 I'_1 + \tfrac{1}{2}(k_{21} + k_{22})\Delta I_1$$

$$H_{DM} = \tfrac{1}{2}(H_{211} - H_{212}) = \tfrac{1}{2}(k_{21} - k_{22})\Delta I_1 \qquad (7).$$

Then, the equation (4) can also be obtained:

$$H_{211} = H_{CM} + H_{DM};$$

$$H_{212} = H_{CM} - H_{DM} \qquad (4).$$

It can be seen from the equation (7) that the magnetic fields generated by $I'_1$ and $I_5$ at the positions of the first magnetic sensing unit 211 and the second magnetic sensing unit 212 are in opposite directions, offset and reduce each other, and only generate a common mode magnetic field $H_{CM}$ without generating a differential mode magnetic field $H_{DM}$, which mainly plays the role of adjusting and increasing the current input range of the current detection device with a stepped copper bar. Similarly, it can be seen by combining the equation (7) and the equation (4) that the magnetic fields at the positions of the first magnetic sensing unit 211 and the second magnetic sensing unit 212 are proportional to the current to be measured $I_{in}$, and the current to be measured can be detected by measuring the differential mode magnetic field $H_{DM}$.

Optionally, the magnetic induction module 2 also includes a closed-loop signal conditioning circuit and a magnetic field feedback coil; the closed-loop signal conditioning circuit performs conditioning, amplification, temperature compensation, and linearity correction on the differential voltage signal; the closed-loop signal conditioning circuit, the magnetic field feedback coil, the first magnetic sensing unit, and the second magnetic sensing unit constitute a closed-loop magnetic field feedback; after the differential voltage signal is amplified by the closed-loop signal conditioning circuit, a feedback magnetic field is generated through the magnetic field feedback coil to reversely offset the differential mode magnetic field; when the dynamic balance of the magnetic field is reached, the first magnetic sensing unit and the second magnetic sensing unit operate at equal common mode magnetic field operating points, and then the feedback current of the magnetic field feedback coil is sampled through a sampling resistor to form an output signal of the magnetic induction module.

Optionally, the magnetic field feedback coil is integrated into one structure of a closed-loop signal conditioning circuit, a circuit board, each magnetic sensing unit of the magnetic induction module, and the magnetic induction module.

As shown in FIG. 5, the closed-loop signal conditioning circuit, the magnetic field feedback coil 22, the first magnetic sensing unit 211, and the second magnetic sensing unit 212 constitute a closed-loop magnetic field negative feedback. For closed-loop magnetic field negative feedback, the magnetic field feedback coil 22 can be integrated into a closed-loop signal conditioning circuit, or integrated into a circuit board 3 as shown in FIG. 5, or integrated into a magnetic sensing unit as shown in FIG. 1, or integrated into an ASIC dedicated integrated circuit, or integrated into a magnetic induction module 2 as needed. The working principles of the closed-loop magnetic field negative feedback components in the above different positions are roughly the same.

Here, the working principle of the closed-loop magnetic field negative feedback component is described by taking the magnetic field feedback coil 22 integrated into the circuit board 3 as shown in FIG. 5 as an example. The plane where the magnetic field feedback coil 22 is located is parallel to the plane where the first magnetic sensing unit 211 and the second magnetic sensing unit 212 are located. The magnetic field feedback coil 22 is symmetrically distributed along the cross-section plane of the X-Z plane on two sides of the centerline, wherein the current direction on one side of the cross-section plane is perpendicular to the paper surface and outward, and the current direction on the other side of the cross-section plane is perpendicular to the paper surface and inward.

Regarding the direction of the feedback magnetic field generated by the magnetic field feedback coil 22, take the example that the rightward magnetic field at the first magnetic sensing unit 211 is greater than the rightward magnetic field at the second magnetic sensing unit 212. In order to reversely offset the differential mode magnetic field, in the cross-sectional view shown in FIG. 5, the current direction of the cross-sectional area of the conductors of the magnetic field feedback coil 22 arranged horizontally below the first magnetic sensing unit 211 is perpendicular to the paper surface and outward, and the current direction of the cross-sectional area of the conductors of the magnetic field feedback coil 22 arranged horizontally below the second magnetic sensing unit 212 is perpendicular to the paper surface and inward. Therefore, the magnetic field feedback coil 22 generates a leftward feedback magnetic field at the first magnetic sensing unit 211, and the magnetic field feedback coil 22 generates a rightward feedback magnetic field at the second magnetic sensing unit 212, thereby reversely offsetting the differential mode magnetic field and achieving dynamic balance of the magnetic field.

As for the cases where the magnetic field feedback coil 22 is integrated at other positions, although the coil distribution or connection is slightly different, the magnetic field feedback principle is to use the distribution of the magnetic field feedback coil 22 to generate a magnetic field to offset the differential mode magnetic field, which will not be repeated here.

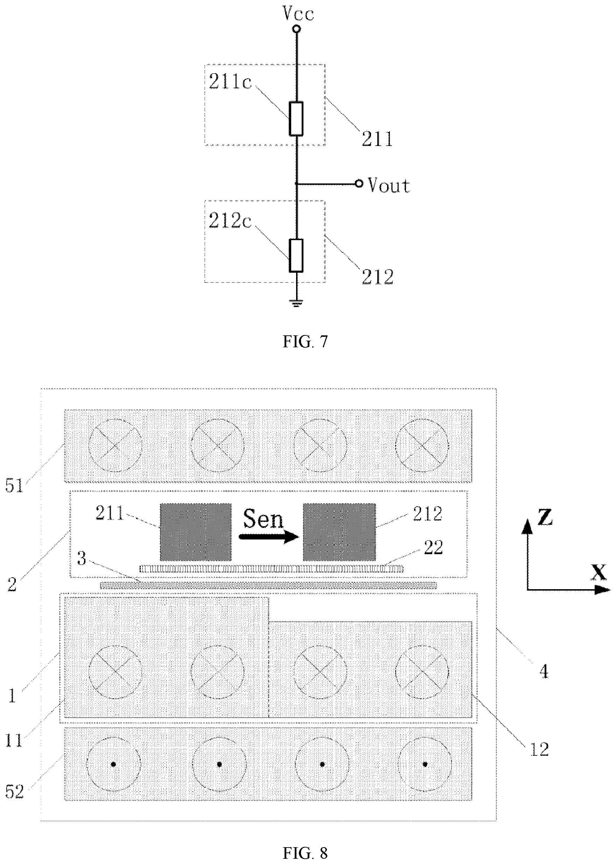

Referring to FIG. 7, which is a schematic diagram of the bridge structure of the current detection device with a stepped copper bar shown in FIG. 5. As shown in FIG. 7, optionally, the first magnetic sensing unit 211 is composed of a magnetoresistive bridge arm 211c, and the second magnetic sensing unit 212 is composed of a magnetoresistive bridge arm 212c. The magnetoresistive bridge arm is composed of one or more magnetoresistive sensitive elements connected in series and parallel. The sensitivity directions of the two magnetoresistive bridge arms are the same, and they are electrically connected to form a differential half-bridge structure.

As shown in FIG. 7, the sensitivity directions of the two magnetoresistive bridge arms 211c and 212c are the same, both in the horizontal rightward X direction, and electrically form a differential half-bridge structure. Optionally, the magnetoresistive sensitive elements forming the magnetoresistive bridge arms 211c and 212c adopt an anisotropic magnetoresistor AMR; and optionally, the first magnetic sensing unit 211 and the second magnetic sensing unit 212 are located on two separate chips.

According to the above analysis, it can be seen that the current shunting copper bar 5 can only offset and reduce the common mode magnetic field, but does not generate a differential mode magnetic field. Therefore, the offset common mode magnetic fields may be of the same direction, zeroed, or of the opposite directions.

Assuming that the offset common mode magnetic fields are of the same direction, then the differential mode magnetic field causes the rightward magnetic field at the position of the first magnetic sensing unit 211 to be greater than the rightward magnetic field at the position of the second magnetic sensing unit 212. Since the sensitivity directions of the two magnetoresistive bridge arms 211c and 212c are both to the right, in FIG. 7, the rightward magnetic field at the magnetoresistive bridge arm 211c is greater than the magnetic field at the magnetoresistive bridge arm 212c. Therefore, the resistance of the magnetoresistive bridge arm 211c is smaller than the resistance of the magnetoresistive bridge arm 212c, realizing the change from magnetic field to voltage. Therefore, Vout in FIG. 7 will change accordingly with the current to be measured, forming a differential voltage signal.

Optionally, the magnetic induction module 2 also includes a magnetic field feedback coil 22 integrated inside the circuit board and a closed-loop signal conditioning circuit using a PCB board-level discrete component circuit. Its function and principle are the same as those of the closed-loop magnetic field negative feedback in FIG. 1, and will not be repeated here. In this embodiment, the output of the magnetic induction module 2 forms the output signal of the current detection device with a stepped copper bar.

In this embodiment, a stepped copper bar and a current shunting copper bar are connected in parallel to shunt the current to be measured to form a to-be-measured current input module, the stepped copper bar forms a differential mode magnetic field, and the common mode magnetic field formed by the current shunting copper bar offsets and reduces the common mode magnetic field of the stepped copper bar, thereby expanding the measurement current range. The first magnetic sensing unit and the second magnetic sensing unit adopt a differential half-bridge circuit, and the magnetic field feedback coil is integrated inside the circuit board. The formed current detection device with a stepped copper bar has the characteristics of adjustable common mode magnetic field working points, applicability to a variety of magnetic sensing units, adjustable sensitivity, input and output electrical isolation, strong anti-common mode interference capability, capability of measuring DC and AC currents, and capability of measuring large currents.

Optionally, the current detection device with a stepped copper bar includes more than one current shunting copper bar, and more than one current shunting copper bar is used in series and parallel connection to further adjust the common mode magnetic field. Along the vertical direction of the circuit board, the position of any current shunting copper bar is above the magnetic induction module or below the stepped copper bar, and the vertical projection of the current shunting copper bar on the plane where the circuit board is located covers each magnetic sensing unit in the magnetic induction module. Optionally, at the position of the magnetic induction module, the current direction of the current shunting copper bar is the same as or opposite to the current direction of the stepped copper bar; in the current detection device with a stepped copper bar, the input range of the current to be measured of the current detection device with a stepped copper bar is adjusted by setting the series-parallel connection mode of the current shunting copper bar and the stepped copper bar, and/or the input range of the current to be measured of the current detection device with a stepped copper bar is adjusted by setting the number of current shunting copper bars.

The following embodiments also provide a case where the current detection device with a stepped copper bar includes two current shunting copper bars. It should be noted that the same contents as those in the above-mentioned embodiment including one current shunting copper bar will not be described in detail.

Referring to FIG. 8, which is a schematic diagram of yet another current detection device with a stepped copper bar according to an embodiment of the present invention. As shown in FIG. 8, the current detection device includes two current shunting copper bars 51 and 52, wherein the current shunting copper bar 51 is located above the magnetic induction module 2, and the current shunting copper bar 52 is located below the stepped copper bar 1. Optionally, the magnetic field feedback coil 22 is integrated inside the magnetic induction module 2.

Through the above analysis, it is known that by adjusting the thickness and relative position of the current shunting copper bar 5 in FIG. 5, the offset common mode magnetic fields may be of the same direction, zeroed, or of the opposite directions. As shown in FIG. 6, the offset common mode magnetic fields of the current shunting copper bar 5 and the stepped copper bar 1 are of the same direction. The position of the first current shunting copper bar 51 in FIG. 8 is the same as the position of the current shunting copper bar 5 in FIG. 5. In order to further reduce the common mode magnetic field to improve the linearity consistency and expand the measurement current range, optionally, the newly introduced second current shunting copper bar 52 can be placed below the stepped copper bar 1, and the current direction in the second current shunting copper bar 52 is perpendicular to the paper surface and outward, while the current direction of the stepped copper bar 1 and the current shunting copper bar 51 is perpendicular to the paper surface and inward.

In other embodiments, optionally, the newly introduced second current shunting copper bar can be placed above the first current shunting copper bar, and the current direction in the second current shunting copper bar is perpendicular to the paper surface and inward.

As shown in FIG. 8, the current shunting copper bar 52 is introduced to be located below the stepped copper bar 1, and the current direction thereof is perpendicular to the paper surface and outward, wherein the current shunting copper bar 51 is connected in parallel with the stepped copper bar 1 and then connected in series with the current shunting copper bar 52. At this time, the main function of the current shunting copper bar 52 is to adjust the common mode magnetic field, the internal current thereof is the same as the current to be measured, and no shunting effect is produced.

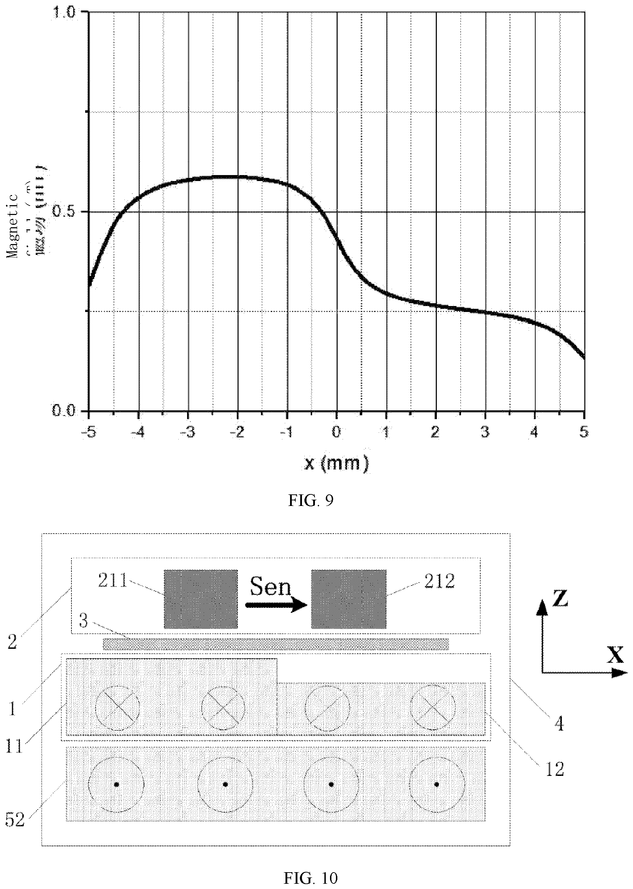

Referring to FIG. 9, which is a magnetic field simulation diagram of the current detection device with a stepped copper bar shown in FIG. 8. The similarities between FIG. 9 and FIG. 6 are that, near the step rising section, the magnetic fields in the same plane above the first step 11 and the second step 12 have an obvious difference, and the magnetic field distribution is relatively uniform; and the difference is that the magnetic field curve shown in FIG. 9 has further significantly shifted downward and is closer to zero magnetic field. That is, the leftward common mode magnetic field generated by the current shunting copper bar 52 at the position of the magnetic sensing unit and the offset rightward common mode magnetic field are further offset and reduced.

Let the current flowing through the current shunting copper bar 51 be $I_{51}$ and the current flowing through the current shunting copper bar 52 be $I_{52}$, then equation (8) is obtained:

$$I_{in}=I_1+I_{51}=I'_1+\Delta I_1+I_{51};$$

$$I_{in}=I_{52} \qquad (8).$$

Taking the rightward X direction as the positive direction of the magnetic field, assuming that the first magnetic sensing unit 211 and the second magnetic sensing unit 212 are located in the uniform magnetic field area of the current shunting copper bar 52, and equation (9) is obtained according to the Biot-Savart Law that a current-carrying wire generates a magnetic field:

$$H_{211}=k_1I'_1+k_{21}\Delta I_1-k_3I_{51}-k_4I_{52};$$

$$H_{212}=k_1I'_1+k_{22}\Delta I_1-k_3I_{51}-k_4I_{52} \qquad (9).$$

wherein $k_4$ is the linear constant of a uniform magnetic field generated by the current $I_{52}$ of the current shunting copper bar 52 at the positions of the first magnetic sensing unit 211 and the second magnetic sensing unit 212.

By performing equivalent transformation on the equation (9), equation (10) is obtained:

$$H_{CM}=\tfrac{1}{2}(H_{211}+H_{212})=-k_3I_{51}-k_4I_{52}+k_1I'_1+\tfrac{1}{2}(k_{21}+k_{22})\Delta I_1$$

$$H_{DM}=\tfrac{1}{2}(H_{211}-H_{212})=\tfrac{1}{2}(k_{21}-k_{22})\Delta I_1 \quad (10).$$

Then, the equation (4) can also be obtained:

$$H_{211}=H_{CM}+H_{DM};$$

$$H_{212}=H_{CM}-H_{DM} \qquad (4).$$

It can be seen from the equation (10) that the magnetic fields generated by $I'_1$, $I_{51}$, and $I_{52}$ at the positions of the first magnetic sensing unit 211 and the second magnetic sensing unit 212 are in opposite directions, offset and reduce each other, and only generate a common mode magnetic field $H_{CM}$ without generating a differential mode magnetic field $H_{DM}$, which mainly plays the role of adjusting and increasing the current input range of the current detection device with a stepped copper bar. Similarly, it can be seen by combining the equation (10) and the equation (4) that the magnetic fields at the positions of the first magnetic sensing unit 211 and the second magnetic sensing unit 212 are proportional to the current to be measured $I_{in}$, and the current to be measured can be detected by measuring the differential mode magnetic field $H_{DM}$.

The magnetoresistive bridge arm in the current detection device with a stepped copper bar shown in FIG. 8 may adopt a differential half-bridge structure as shown in FIG. 7, wherein the current shunting copper bar 51 and the current shunting copper bar 52 only offset and reduce the common mode magnetic field without generating a differential mode magnetic field. Then, the output signal Vout of the differential half-bridge structure will change accordingly with the current to be measured, forming a differential voltage signal.

Optionally, the magnetic induction module 2 also includes a magnetic field feedback coil 22 integrated inside the magnetic sensing unit 2 and a closed-loop signal conditioning circuit using a PCB board-level discrete component circuit. The output of the magnetic induction module 2 forms an output signal of the current detection device with a stepped copper bar.

In this embodiment, a first current shunting copper bar and a stepped copper bar are connected in parallel, and then is further connected in series with a second current shunting copper bar to form a to-be-measured current input module, the stepped copper bar forms a differential mode magnetic field, and the common mode magnetic field formed by the first current shunting copper bar and the second current shunting copper bar offsets and reduces the common mode magnetic field of the stepped copper bar, thereby expanding the measurement current range. The current detection device with a stepped copper bar has the characteristics of adjustable common mode magnetic field working points, applicability to a variety of magnetic sensing units, adjustable sensitivity, input and output electrical isolation, strong anti-common mode interference capability, capability of measuring DC and AC currents, and capability of measuring large currents.

The following embodiments also provide a case where the current detection device with a stepped copper bar includes one current shunting copper bar. It should be noted that the same contents as those in the above-mentioned embodiments including one or two current shunting copper bars will not be described in detail. Furthermore, optionally, the current detection device with a stepped copper bar includes one current shunting copper bar, which may be placed below the stepped copper bar, and the current direction in the current shunting copper bar is perpendicular to the paper surface and outward. Referring to FIG. 10, which is a schematic diagram of still another current detection device with a stepped copper bar according to an embodiment of the present invention. As shown in FIG. 10, the current detection device includes one current shunting copper bar 52, which is located below the stepped copper bar 1, the current shunting copper bar 52 is directly connected in series with the stepped copper bar 1, and the current direction of the stepped copper bar 1 is perpendicular to the paper surface and inward. The specific analysis process is as follows.

Let the current flowing through the current shunting copper bar 52 be $I_{52}$, then equation (11) is obtained:

$$I_{in}=I_1=I_{52} \quad (11).$$

Taking the rightward X direction as the positive direction of the magnetic field, assuming that the first magnetic sensing unit 211 and the second magnetic sensing unit 212 are located in the uniform magnetic field area of the current shunting copper bar 52, and equation (12) is obtained according to the Biot-Savart Law that a current-carrying wire generates a magnetic field:

$$H_{211}=k_1I'_1+k_{21}\Delta I_1-k_4I_{52};$$

$$H_{212}=k_1I'_1+k_{22}\Delta I_1-k_4I_{52} \quad (12).$$

By performing equivalent transformation on the equation (12), equation (13) is obtained:

$$H_{CM}=\frac{1}{2}(H_{211}+H_{212})=-k_4I_{52}+k_1I'_1+\frac{1}{2}(k_{21}+k_{22})\Delta I_1 \quad (13).$$

$$H_{DM}=\frac{1}{2}(H_{211}-H_{212})=\frac{1}{2}(k_{21}-k_{22})\Delta I_1$$

Then, the equation (4) can also be obtained:

$$H_{211}=H_{CM}+H_{DM};$$

$$H_{212}=H_{CM}-H_{DM} \quad (4).$$

It can be seen that the magnetic fields generated by $I'_1$ and $I_{52}$ at the positions of the first magnetic sensing unit 211 and the second magnetic sensing unit 212 are in opposite directions, offset and reduce each other, and only generate a common mode magnetic field $H_{CM}$ without generating a differential mode magnetic field $H_{DM}$, which mainly plays the role of adjusting and increasing the current input range of the current detection device with a stepped copper bar. Similarly, it can be seen by combining the equation (13) and the equation (4) that the magnetic fields at the positions of the first magnetic sensing unit 211 and the second magnetic sensing unit 212 are proportional to the current to be measured $I_{in}$, and the current to be measured can be detected by measuring the differential mode magnetic field $H_{DM}$.

Optionally, the first magnetic sensing unit 211 and the second magnetic sensing unit 212 are two separately placed giant magneto-impedance (GMI) units with a rightward sensitivity direction. According to the above analysis, there is a difference in the magnetic fields generated by the stepped copper bar 1 at the position of the first magnetic sensing unit 211 and the position of the second magnetic sensing unit 212, and the current shunting copper bar 52 can only offset and reduce the common mode magnetic field without generating a differential mode magnetic field. Therefore, there is a difference in the magnetic fields induced by the two separately placed giant magneto-impedance GMIs, which can generate a differential voltage signal.

Optionally, the magnetic induction module 2 also includes an open-loop signal conditioning circuit, which performs conditioning, amplification, temperature compensation, and linearity correction on the differential voltage signal. Specifically, the open-loop signal conditioning circuit uses a PCB board-level discrete component circuit, and the open-loop signal conditioning circuit performs conditioning, amplification, temperature compensation, and linearity correction on the differential voltage signal of the first magnetic sensing unit 211 and the second magnetic sensing unit 212. The output of the magnetic induction module 2 forms the output signal of the current detection device with a stepped copper bar.

In this embodiment, one current shunting copper bar is connected in series with the stepped copper barbar, and the current directions of the two are opposite to each other. The stepped copper bar forms a differential mode magnetic field, and the common mode magnetic field formed by the current shunting copper bar offsets and reduces the common mode magnetic field of the stepped copper bar, thereby expanding the measurement current range. The current detection device in this embodiment has the characteristics of adjustable common mode magnetic field working points, applicability to a variety of magnetic sensing units, adjustable sensitivity, input and output electrical isolation, strong anti-common mode interference capability, capability of measuring DC and AC currents, and capability of measuring large currents.

The above-mentioned several embodiments that include the current shunting copper bar are only typical cases. For example, in other embodiments, a current detection device may include a current shunting copper bar. The first magnetic sensing unit is composed of two magnetoresistive bridge arms, and the second magnetic sensing unit is composed of two magnetoresistive bridge arms. The magnetoresistive bridge arms are composed of one or more magnetoresistive sensitive elements connected in series and parallel. The four magnetoresistive bridge arms have the same sensitivity direction, and are electrically connected to form a differential full-bridge structure. The first magnetic sensing unit and the second magnetic sensing unit are located on the same chip or on two separate chips. Obviously, there are many other embodiments that include the current shunting copper bar, which are not limited to the above typical embodiments.

It can be understood that there are many embodiments that include the current shunting copper bar, but after introducing one or more current shunting copper bars and adopting a series-parallel connection method, the analysis and calculation thereof are roughly the same as the above analysis process. In addition, no matter which case is adopted, for the current detection device with a stepped copper bar with the current shunting copper bar introduced, the ideal condition in most applications is that the common mode magnetic field is completely offset. At this point, the measurement current range of the current detection device with a stepped copper bar can reach the maximum, that is, the differential mode magnetic field can be fully extended to the working range of the magnetoresistive sensitive element, and then the following equations (14) and (15) can be obtained:

$$H_{CM} = \frac{1}{2}(H_{211} + H_{212}) = 0 \qquad (14);$$

$$H_{DM} = \frac{1}{2}(H_{211} - H_{212}) = \frac{1}{2}(k_{21} - k_{22})\Delta I_1$$

$$H_{41} = H_{CM} + H_{DM} = H_{DM} = \frac{1}{2}(k_{21} - k_{22})\Delta I_1$$

$$H_{42} = H_{CM} - H_{DM} = -H_{DM} = -\frac{1}{2}(k_{21} - k_{22})\Delta I_1 \qquad (15).$$

Furthermore, in an ideal situation, the magnetic field generated by the upper rectangular current $\Delta I_1$ at the position of the second magnetic sensing unit 42 is very small, and it can be approximately considered that $k_{22} = 0$, then the above equation (14) can be simplified to the following equations (16) and (17):

$$H_{CM} = 0$$

$$H_{DM} = \frac{1}{2}k_{21}\Delta I_1 \qquad (16);$$

$$H_{211} = H_{DM} = k_{21}\Delta I_1/2, H_{212} = -H_{DM} = -k_{21}\Delta I_1/2, \qquad (17).$$

The magnetic fields at the positions of the first magnetic sensing unit 211 and the second magnetic sensing unit 212 are proportional to the current to be measured $I_{in}$, and the current to be measured can be detected by measuring the differential mode magnetic field $H_{DM}$. Moreover, by combining the equations (16) and (17), it can be seen that under ideal conditions, the common mode magnetic field $H_{CM}$ is completely offset, and the working range of the magnetoresistive sensitive element can be completely covered by the differential mode magnetic field $H_{DM}$, providing the maximum measurement current range.

It should be noted that the above descriptions are merely the preferred embodiments and used technical principles of the present invention. A person skilled in the art should understand that the present invention is not limited to the specific embodiments herein, and for a person skilled in the art, various obvious variations, readjustments, mutual combinations, and replacements may be made without departing from the protection scope of the present invention. Therefore, although the present invention is described in detail through the above embodiments, the present invention is not merely limited to the above embodiments, and without departing from the conception of the present invention, more other equivalent embodiments may be further included, while the scope of the present invention is defined by the appended claims.

**Claims**

1. A current detection device with a stepped copper bar, **characterized by** comprising:

   a circuit board;
   a magnetic induction module secured on the circuit board, the magnetic induction module at least comprising a first magnetic sensing unit and a second magnetic sensing unit, wherein the first magnetic sensing unit and the second magnetic sensing unit are located on the same horizontal plane, and the horizontal plane is parallel to the plane where the circuit board is located; and
   a stepped copper bar, wherein the side of the stepped copper bar facing the magnetic induction module is stepped, the stepped copper bar comprises at least a first step and a second step different from the first step; in a direction perpendicular to the circuit board,
   the first magnetic sensing unit is located above the first step, and the second magnetic sensing unit is located above the second step; and the stepped copper bar is electrically isolated from the magnetic induction module;

   wherein a current to be measured flows through a cross section perpendicular to the stepped copper bar, and the first magnetic sensing unit and the second magnetic sensing unit sense, in a differential manner, the differential mode magnetic field generated by the current to be measured flowing through the stepped copper bar, and generate and output a differential voltage signal.

2. The current detection device with a stepped copper bar according to claim 1, **characterized in that** the sensitivity directions of the magnetic sensing units in the magnetic induction module are the same, and the sensitivity directions of the magnetic sensing units are the same as or opposite to the direction of the magnetic field generated by the stepped copper bar at the positions of the magnetic sensing units.

3. The current detection device with a stepped copper bar according to claim 1, **characterized in that** it also includes: a mechanical support housing, which wraps, fixes, and supports the magnetic induction module and the stepped copper bar.

4. The current detection device with a stepped copper bar according to claim 1, **characterized in that** the first magnetic sensing unit includes at least one magnetoresistive bridge arm, and the second magnetic sensing unit includes at least one magnetoresistive bridge arm;

   the magnetoresistive bridge arm of the first magnetic sensing unit and the magnetoresistive bridge arm of the second magnetic sensing unit are electrically connected to form a differential half-bridge structure output or connected to form a differential full-bridge structure output, wherein all magnetoresistive bridge arms have the same sensitivity direction, and are formed by connecting at least one magnetoresistive sensitive element in series and parallel; and
   the first magnetic sensing unit and the second magnetic sensing unit are located on the same chip or on two separate chips.

5. The current detection device with a stepped copper bar according to claim 1, **characterized in that** the magnetic induction module also includes a closed-loop signal conditioning circuit and a magnetic field feedback coil, and the closed-loop signal conditioning circuit, the magnetic field feedback coil, the first magnetic sensing unit, and the second magnetic sensing unit constitute a closed-loop magnetic field feedback component;

   after the differential voltage signal is amplified by the closed-loop signal conditioning circuit, a feedback magnetic field is generated through the magnetic field feedback coil to reversely offset the differential mode magnetic field;

when the dynamic balance of the magnetic field is reached, the first magnetic sensing unit and the second magnetic sensing unit operate at equal common mode magnetic field operating points, and then the feedback current of the magnetic field feedback coil is sampled through a sampling resistor to form an output signal of the magnetic induction module; or,

the magnetic induction module also includes an open-loop signal conditioning circuit, which performs conditioning, amplification, temperature compensation, and linearity correction on the differential voltage signal.

6. A current detection device with a stepped copper bar, **characterized by** comprising:

a stepped copper bar,
a current shunting copper bar,
a magnetic induction module, and
a circuit board, wherein the magnetic induction module is secured on the circuit board;
the stepped copper bar and the current shunting copper bar are connected in series and parallel to form a to-be-measured current input module, the magnetic induction module and the circuit board form a signal output module, and the to-be-measured current input module is electrically isolated from the signal output module;
the side of the stepped copper bar facing the magnetic induction module is stepped, and the stepped copper bar comprises at least a first step and a second step;
the magnetic induction module at least includes a first magnetic sensing unit and a second magnetic sensing unit, the first magnetic sensing unit and the second magnetic sensing unit are located on the same horizontal plane, the horizontal plane is parallel to the plane where the circuit board is located, and in a direction perpendicular to the circuit board, the first magnetic sensing unit is located above the first step, and the second magnetic sensing unit is located above the second step;
a current to be measured flows through a cross section perpendicular to the stepped copper bar and the current shunting copper bar, and generates a magnetic field at the position of the magnetic induction module; the first magnetic sensing unit and the second magnetic sensing unit sense, in a differential manner, the magnetic field generated by the current to be measured flowing through the to-be-measured current input module, and generate a voltage signal, which forms an output signal of the current detection device with a stepped copper bar.

7. The current detection device with a stepped copper bar according to claim 6, **characterized in that**, in a direction perpendicular to the circuit board, the vertical projection of the current shunting copper bar on the circuit board covers the vertical projection of each magnetic sensing unit in the magnetic induction module on the circuit board; the sensitivity direction of each magnetic sensing unit is the same, the sensitivity direction of the magnetic sensing unit is the same as or opposite to the direction of the magnetic field generated by the stepped copper bar at the position of the magnetic sensing unit, and the sensitivity direction of the magnetic sensing unit is along the plane of the magnetic induction module and perpendicular to the step rising cross-section direction of the stepped copper bar.

8. The current detection device with a stepped copper bar according to claim 6, **characterized in that** the first magnetic sensing unit and the second magnetic sensing unit are located on the same circuit board; or,
the first magnetic sensing unit and the second magnetic sensing unit are located on two separate circuit boards.

9. The current detection device with a stepped copper bar according to claim 6, **characterized in that** the first magnetic sensing unit is composed of a magnetoresistive bridge arm, the second magnetic sensing unit is composed of a magnetoresistive bridge arm, the magnetoresistive bridge arm is composed of one or more magnetoresistive sensitive elements connected in series and parallel, and the two magnetoresistive bridge arms have the same sensitivity direction and are electrically connected to form a differential half-bridge structure;
or,

the first magnetic sensing unit is composed of two magnetoresistive bridge arms, the second magnetic sensing unit is composed of two magnetoresistive bridge arms, the magnetoresistive bridge arm is composed of one or more magnetoresistive sensitive elements connected in series and parallel, and the four magnetoresistive bridge arms have the same sensitivity direction and are electrically connected to form a differential full-bridge structure; and
the first magnetic sensing unit and the second magnetic sensing unit are located on the same chip or on two separate chips.

10. The current detection device with a stepped copper bar according to claim 6, **characterized in that** the magnetic induction module also includes an open-loop signal conditioning circuit, and the open-loop signal conditioning circuit performs conditioning, amplification, temperature compensation, and linearity correction on the differential voltage signal; or,

the magnetic induction module also includes a closed-loop signal conditioning circuit and a magnetic field feedback coil; the closed-loop signal conditioning circuit performs conditioning, amplification, temperature compensation, and linearity correction on the differential voltage signal; the closed-loop signal conditioning circuit, the magnetic field feedback coil, the first magnetic sensing unit, and the second magnetic sensing unit constitute a closed-loop magnetic field feedback; after the differential voltage signal is amplified by the closed-loop signal conditioning circuit, a feedback magnetic field is generated through the magnetic field feedback coil to reversely offset the differential mode magnetic field; when the dynamic balance of the magnetic field is reached, the first magnetic sensing unit and the second magnetic sensing unit operate at equal common mode magnetic field operating points, and then the feedback current of the magnetic field feedback coil is sampled through a sampling resistor to form an output signal of the magnetic induction module.

11. The current detection device with a stepped copper bar according to any one of claims 6 to 10, **characterized in that** the number of the current shunting copper bars is one or more;
along the vertical direction of the circuit board, the position of any current shunting copper bar is above the magnetic induction module or below the stepped copper bar, and the vertical projection of the current shunting copper bar on the plane where the circuit board is located covers each magnetic sensing unit in the magnetic induction module.

12. The current detection device with a stepped copper bar according to claim 11, **characterized in that**:

at the position of the magnetic induction module, the current direction of the current shunting copper bar is the same as or opposite to the current direction of the stepped copper bar;
in the current detection device with a stepped copper bar, the input range of the current to be measured of the current detection device with a stepped copper bar is adjusted by setting the series-parallel connection mode of the current shunting copper bar and the stepped copper bar, and/or the input range of the current to be measured of the current detection device with a stepped copper bar is adjusted by setting the number of the current shunting copper bars.

FIG. 1

FIG. 2

EP 4 455 686 A1

FIG. 3

FIG. 4

FIG. 5

FIG. 6

FIG. 7

FIG. 8

FIG. 9

FIG. 10

## INTERNATIONAL SEARCH REPORT

| International application No. |
| --- |
| **PCT/CN2022/132437** |

**A. CLASSIFICATION OF SUBJECT MATTER**

G01R19/00(2006.01)i

According to International Patent Classification (IPC) or to both national classification and IPC

**B. FIELDS SEARCHED**

Minimum documentation searched (classification system followed by classification symbols)

G01R19

Documentation searched other than minimum documentation to the extent that such documents are included in the fields searched

Electronic data base consulted during the international search (name of data base and, where practicable, search terms used)

CNTXT, CNKI, ENTXTC, WPABSC, DWPI, VEN: 电流, 测, 电流传感器, 电流互感器, 铜排, 台阶, 阶梯, 磁传感器, 磁感应, 磁阻, 磁电阻, 磁场, 线路板, 电路板, 基板, 差分, 差模, 反馈线圈, current, measure, detect, current sensor, current transducer, copper, step, ladder, busbar, magnetic, PCB, differential, feedback loop, feedback winding

**C. DOCUMENTS CONSIDERED TO BE RELEVANT**

| Category* | Citation of document, with indication, where appropriate, of the relevant passages | Relevant to claim No. |
| --- | --- | --- |
| PX | CN 114264860 A (JIANGSU MULTIDIMENSION TECHNOLOGY CO., LTD.) 01 April 2022 (2022-04-01)<br>claims 1-12 | 1-12 |
| Y | CN 112542439 A (INFINEON TECHNOLOGIES AG.) 23 March 2021 (2021-03-23)<br>description, paragraphs 3-62, and figures 3-4 | 1-12 |
| Y | US 2010026286 A1 (INFINEON TECHNOLOGIES AG.) 04 February 2010 (2010-02-04)<br>description, paragraphs 3-29, and figures 1, 3 and 7 | 1-12 |
| Y | CN 109791169 A (MURATA MANUFACTURING CO., LTD.) 21 May 2019 (2019-05-21)<br>description, paragraphs 70-104 and 277-282, and figures 4-6 and 28-30 | 1-12 |
| Y | CN 111033276 A (MURATA MANUFACTURING CO., LTD.) 17 April 2020 (2020-04-17)<br>description, paragraphs 14-95 and 165-171, and figures 1 and 15 | 1-12 |
| Y | CN 103134973 A (TOYOTA JIDOSHOKKI K.K. et al.) 05 June 2013 (2013-06-05)<br>description, paragraphs 6-48, and figures 2-5 | 1-12 |

☑ Further documents are listed in the continuation of Box C.　　☑ See patent family annex.

| | |
| --- | --- |
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **12 February 2023** | **15 February 2023** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

**INTERNATIONAL SEARCH REPORT**

International application No.

**PCT/CN2022/132437**

**C. DOCUMENTS CONSIDERED TO BE RELEVANT**

| Category* | Citation of document, with indication, where appropriate, of the relevant passages | Relevant to claim No. |
|---|---|---|
| Y | JP 2018165699 A (ASAHI KASEI DENSHI K.K.) 25 October 2018 (2018-10-25) description, paragraphs 4-56, and figures 1-2, 4 and 7 | 1-12 |
| A | CN 109613322 A (WUXI LERTECH CO., LTD.) 12 April 2019 (2019-04-12) entire document | 1-12 |
| A | CN 109752586 A (WUXI LERTECH CO., LTD.) 14 May 2019 (2019-05-14) entire document | 1-12 |
| A | JP 2005195427 A (ASAHI KASEI DENSHI K.K.) 21 July 2005 (2005-07-21) entire document | 1-12 |
| A | WO 2015115472 A1 (HITACHI METALS LTD.) 06 August 2015 (2015-08-06) entire document | 1-12 |

Form PCT/ISA/210 (second sheet) (July 2022)

**INTERNATIONAL SEARCH REPORT**
**Information on patent family members**

International application No.

**PCT/CN2022/132437**

| Patent document cited in search report | | | Publication date (day/month/year) | Patent family member(s) | | | Publication date (day/month/year) |
|---|---|---|---|---|---|---|---|
| CN | 114264860 | A | 01 April 2022 | None | | | |
| CN | 112542439 | A | 23 March 2021 | US | 2021088600 | A1 | 25 March 2021 |
| | | | | US | 11385301 | B2 | 12 July 2022 |
| | | | | DE | 102019125537 | B3 | 18 February 2021 |
| US | 2010026286 | A1 | 04 February 2010 | DE | 102009034233 | A1 | 18 February 2010 |
| | | | | DE | 102009034233 | B4 | 10 October 2019 |
| | | | | US | 2011101973 | A1 | 05 May 2011 |
| | | | | US | 8258776 | B2 | 04 September 2012 |
| | | | | US | 7915885 | B2 | 29 March 2011 |
| CN | 109791169 | A | 21 May 2019 | JPWO | 2018092336 | A1 | 24 June 2019 |
| | | | | US | 2019154735 | A1 | 23 May 2019 |
| | | | | US | 10989741 | B2 | 27 April 2021 |
| | | | | WO | 2018092336 | A1 | 24 May 2018 |
| CN | 111033276 | A | 17 April 2020 | WO | 2019038964 | A1 | 28 February 2019 |
| CN | 103134973 | A | 05 June 2013 | JP | 2013113687 | A | 10 June 2013 |
| | | | | JP | 5731363 | B2 | 10 June 2015 |
| JP | 2018165699 | A | 25 October 2018 | None | | | |
| CN | 109613322 | A | 12 April 2019 | None | | | |
| CN | 109752586 | A | 14 May 2019 | None | | | |
| JP | 2005195427 | A | 21 July 2005 | None | | | |
| WO | 2015115472 | A1 | 06 August 2015 | JPWO | 2015115472 | A1 | 23 March 2017 |
| | | | | JP | 6582996 | B2 | 02 October 2019 |